# EUROPÄISCHE PATENTSCHRIFT

(11) **EP 1 966 858 B1**
(45) Veröffentlichungstag und Bekanntmachung des Hinweises auf die Patenterteilung: **15.06.2011**
(21) Anmeldenummer: 06849018.4
(22) Anmeldetag: 29.12.2006
(51) Int. Cl.: H01S 5/022, H01S 5/04, H01S 5/06, H01S 5/183, H01S 5/40, H01S 5/00, H01S 5/024

(54) **VERTIKAL EMITTIERENDER, OPTISCH GEPUMPTER HALBLEITER MIT EXTERNEM RESONATOR UND FREQUENZVERDOPPLUNG AUF SEPARATEM SUBSTRAT**
VERTICALLY EMITTING, OPTICALLY PUMPED SEMICONDUCTOR COMPRISING AN EXTERNAL RESONATOR AND FREQUENCY DOUBLING ON A SEPARATE SUBSTRATE
SEMI-CONDUCTEUR A POMPAGE OPTIQUE ET A EMISSION VERTICALE, DOTE D'UN RESONATEUR EXTERNE ET D'UN DOUBLEMENT DE FREQUENCE SUR SUBSTRAT SEPARE

(30) Priorität: 30.12.2005 DE 102005063104; 12.04.2006 DE 102006017294
(43) Veröffentlichungstag der Anmeldung: 10.09.2008
(73) Patentinhaber: OSRAM Opto Semiconductors GmbH, 93055 Regensburg (DE)
(72) Erfinder: STEEGMÜLLER, Ulrich, 93055 Regensburg (DE); SINGER, Frank, 93128 Regenstauf (DE); SCHWARZ, Thomas, 93055 Regensburg (DE); KÜHNELT, Michael, 93051 Regensburg (DE)
(74) Vertreter: Epping - Hermann - Fischer
(86) Internationale Anmeldenummer: PCT/DE2006/002332
(87) Internationale Veröffentlichungsnummer: WO 2007/076841

(56) Entgegenhaltungen:
- WO-A-2006/012819
- WO-A-2006/032252
- DE-A1-102004 012 014
- US-A- 5 436 920
- US-A- 5 637 885
- US-A- 6 130 901
- US-A1- 2005 276 301
- US-A1- 2006 274 807

## Beschreibung

Es wird eine optisch pumpbare Halbleitervorrichtung angegeben. Darüber hinaus wird eine optische Projektionsvorrichtung mit solch einer Halbleitervorrichtung angegeben.

Die Druckschrift DE 10 2004 012 014 A1 beschreibt einen Scheibenlaser mit einer Pumpanordnung.

Die Druckschrift US 5,436,920 beschreibt einen Halbleiterlaser.

Die Druckschrift US 5,637,885 beschreibt ein Verfahren zur Herstellung eines Mikrolasers.

Die Druckschrift US 6,130,901 beschreibt ein Bauteil zur Stabilisierung eines SHG Lasers.

Eine zu lösende Aufgabe besteht darin, eine besonders kompakte Halbleitervorrichtung anzugeben.

Die Erfindung betrifft eine Halbleitervorrichtung gemäß Anspruch 1. Vorteilhafte Ausgestaltungen der Halbleitervorrichtung sind Gegenstand der abhängigen Ansprüche.

Gemäß zumindest einer Ausführungsform der Halbleitervorrichtung weist die Halbleitervorrichtung einen oberflächenemittierenden Halbleiterkörper auf. Der Halbleiterkörper weist eine Strahlungsdurchtrittsfläche auf, durch die elektromagnetische Strahlung in den Halbleiterkörper eingekoppelt und aus dem Halbleiterkörper ausgekoppelt werden kann. Insbesondere ist der Halbleiterkörper durch die Strahlungsdurchtrittsfläche optisch pumpbar. Das bedeutet, Pumpstrahlung, die durch die Strahlungsdurchtrittsfläche in den Halbleiterkörper eingekoppelt wird, regt im Halbleiterkörper die Erzeugung elektromagnetischer Strahlung an, die den Halbleiterkörper dann wiederum durch die Strahlungsdurchtrittsfläche verlässt. Der Halbleiterkörper ist dabei geeignet, unter Verwendung eines extern angeordneten, das heißt vom Halbleiterkörper beabstandet angeordneten Resonatorspiegel Laserstrahlung zu erzeugen.

Gemäß zumindest einer Ausführungsform der optisch pumpbaren Halbleitervorrichtung ist die Strahlungsdurchtrittsfläche einer Montageebene des Halbleiterkörpers abgewandt. Unter Montageebene ist beispielsweise die Haupterstreckungsebene eines ersten Trägers zu verstehen, auf dem der Halbleiterkörper befestigt ist. Auf den gleichen Träger können dann weitere Elemente der Halbleitervorrichtung befestigt sein. Die Strahlungsdurchtrittsfläche verläuft vorzugsweise parallel oder im Wesentlichen parallel zur Montageebene des Halbleiterkörpers. "Im Wesentlichen parallel" bedeutet dabei, dass aufgrund von zum Beispiel Montagetoleranzen die Strahlungsdurchtrittsfläche auch einen kleinen Winkel mit der Montageebene des Halbleiterkörpers einschließen kann. Die vom Halbleiterkörper im Betrieb emittierte Strahlung, die durch die Strahlungsdurchtrittsfläche austritt, verläuft senkrecht oder im Wesentlichen senkrecht zur Montageebene des Halbleiterkörpers und ist von der Montageebene weggerichtet. Beispielsweise umfasst die Halbleiterlaservorrichtung dabei genau eine Pumpstrahlquelle.

Gemäß zumindest einer Ausführungsform der optisch pumpbaren Halbleitervorrichtung weist die Halbleitervorrichtung zusätzlich zum Halbleiterkörper ein optisches Element auf, das geeignet ist, Pumpstrahlung auf die Strahlungsdurchtrittsfläche des Halbleiterkörpers zu lenken. Das bedeutet, Pumpstrahlung ist von einer Pumpstrahlungsquelle nicht direkt auf die Strahlungsdurchtrittsfläche des Halbleiterkörpers gerichtet, sondern die Pumpstrahlung durchläuft oder trifft auf zumindest ein optisches Element, das die Pumpstrahlung auf die Strahlungsdurchtrittsfläche des Halbleiterkörpers lenkt.

Gemäß zumindest einer Ausführungsform der optisch pumpbaren Halbleitervorrichtung weist die Halbleitervorrichtung einen oberflächenemittierenden Halbleiterkörper auf, der eine Strahlungsdurchtrittsfläche umfasst, die einer Montageebene des Halbleiterkörpers abgewandt ist. Ferner weist die Halbleitervorrichtung ein optisches Element auf, das geeignet ist, Pumpstrahlung auf die Strahlungsdurchtrittsfläche des Halbleiterkörpers zu lenken.

Gemäß zumindest einer Ausführungsform der optisch pumpbaren Halbleitervorrichtung umfasst die Halbleitervorrichtung eine Pumpstrahlungsquelle. Vorzugsweise ist als Pumpstrahlungsquelle ein Halbleiterlaserbauelement wie zum Beispiel ein kantenemittierender Halbleiterlaser oder ein kantenemittierender Halbleiterlaserbarren vorgesehen. Die Pumpstrahlungsquelle kann dabei neben einem zur Strahlungserzeugung geeigneten Halbleiterkörper auch ein Wärmeleitelement umfassen, auf das der Halbleiterköper aufgebracht ist. Der Verbund aus Wärmeleitelement und strahlungsemittierenden Halbleiterkörper bildet dann die Pumpstrahlungsquelle der Halbleitervorrichtung.

Gemäß zumindest einer Ausführungsform der optisch pumpbaren Halbleitervorrichtung ist die Pumpstrahlungsquelle in einer Ebene parallel zur Montageebene oder in der Montageebene des Halbleiterkörpers befestigt. Dazu können Pumpstrahlungsquelle und oberflächenemittierender Halbleiterkörper beispielsweise auf einem gemeinsamen ersten Träger aufgebracht und befestigt sein. Ferner ist es möglich, dass Pumpstrahlungsquelle und oberflächenemittierender Halbleiterkörper auf je einem eigenen Träger aufgebracht sind und die beiden Träger mechanisch miteinander verbunden sind.

Gemäß zumindest einer Ausführungsform der optisch pumpbaren Halbleitervorrichtung sind der oberflächenemittierende Halbleiterkörper, das optische Element zum Lenken der Pumpstrahlung auf die Strahlungsdurchtrittsfläche des Halbleiterkörpers sowie die Pumpstrahlungsquelle auf einem gemeinsamen ersten Träger aufgebracht. Diese Elemente der Halbleitervorrichtung können beispielsweise in einer gemeinsamen Montageebene oder in zueinander parallel verlaufenden Montageebenen auf dem gemeinsamen Träger aufgebracht sein.

Gemäß zumindest einer Ausführungsform der optisch pumpbaren Halbleitervorrichtung ist der erste Träger durch einen Anschlussträger gebildet. Vorzugsweise ist die Pumpstrahlungsquelle elektrisch an den Anschlussträger angeschlossen. Beim Anschlussträger handelt es sich beispielsweise um eine Leiterplatte. Der Anschlussträger kann einen Grundkörper aus einem elektrisch isolierenden, gut wärmeleitenden Material umfassen. Auf oder an beispielsweise der Oberseite des Anschlussträgers - diejenige Seite, auf der auch der Halbleiterkörper aufgebracht ist - können elektrische Leiterbahnen aufgebracht sein. Mittels der Leiterbahnen kann beispielsweise die Pumpstrahlungsquelle der Halbleitervorrichtung elektrisch kontaktiert sein.

Gemäß zumindest einer Ausführungsform der Halbleitervorrichtung ist das optische Element geeignet, die Pumpstrahlung durch optische Brechung auf die Strahlungsdurchtrittsfläche des Halbleiterkörpers zu lenken. Das heißt beim Durchlaufen der Strahlungsdurchtrittsflächen des optischen Elements wird die Pumpstrahlung aufgrund des Brechungsindexunterschieds des optischen Elements und des umgebenden Materials - beispielsweise Luft - derart umgelenkt, dass die Pumpstrahlung nach Durchlaufen des optischen Elements auf die Strahlungsdurchtrittsfläche des Halbleiterkörpers gerichtet ist.

Gemäß zumindest einer Ausführungsform der Halbleitervorrichtung ist das optische Element geeignet, die Pumpstrahlung durch eine Reflexion auf die Strahlungsdurchtrittsfläche des Halbleiterkörpers zu lenken. Das heißt es handelt sich bei dem optischen Element um ein reflektierendes optisches Element. Vorzugsweise ist das optische Element geeignet, die Pumpstrahlung durch eine einzige Reflexion auf die Strahlungsdurchtrittsfläche des Halbleiterkörpers zu lenken. Das heißt bei dem optischen Element handelt es sich vorzugsweise nicht um einen Lichtleiter, bei dem Pumpstrahlung durch eine Mehrzahl von Reflexionen umgelenkt wird. Beispielsweise handelt es sich bei dem optischen Element um einen hochreflektierenden Spiegel. Beispielsweise handelt es sich bei dem Spiegel um einen ebenen Spiegel. Das heißt es handelt sich dann zum Beispiel bei dem Spiegel nicht um einen Konkavspiegel.

Im Betrieb der Halbleitervorrichtung läuft Pumpstrahlung zum Beispiel zumindest streckenweise zunächst parallel oder im Wesentlichen parallel zur Strahlungsdurchtrittsfläche des Halbleiterkörpers. Die Pumpstrahlung kann beispielsweise über die Strahlungsdurchtrittsfläche des Halbleiterkörpers hinweg verlaufen. Das heißt die Pumpstrahlung verläuft zunächst über den Halbleiterkörper hinweg, ohne auf den Halbleiterkörper zu treffen. Das reflektierende optische Element ist dem Halbleiterkörper dann in Richtung der Pumpstrahlung nachgeordent. Die Pumpstrahlung trifft - nachdem sie den Halbleiterkörper und damit die Strahlungsdurchtrittsfläche des Halbleiterkörpers überquert hat - auf das reflektierende optische Element. Vom reflektierenden optischen Element wird die Pumpstrahlung durch eine - vorzugsweise genau eine - Reflexion auf die Strahlungsdurchtrittsfläche des Halbleiterkörpers gelenkt. Die umgelenkte Pumpstrahlung kann dabei - zumindest für eine kurze Wegstrecke - in entgegengesetzter Richtung zu der Richtung der Pumpstrahlung verlaufen, die die Pumpstrahlung vor Auftreffen auf das reflektierende optische Element hat.

Gemäß zumindest einer Ausführungsform der Halbleitervorrichtung ist das optische Element geeignet, die Pumpstrahlung in Richtung der Montageebene des Halbleiterkörpers zu lenken. Das heißt die Pumpstrahlung verläuft zunächst für eine bestimmte Wegstrecke parallel zur Montageebene oder ist von der Montageebene weggerichtet bevor sie auf das optische Element trifft. In jedem Fall verläuft die Pumpstrahlung für diese Wegstrecke in einer bestimmten Höhe über der Montageebene und vorzugsweise auch über der Strahlungsdurchtrittsfläche des Halbleiterkörpers. Das optische Element ist geeignet, die Pumpstrahlung nach unten - in Richtung der Montageebene und damit in Richtung der Strahlungsdurchtrittsfläche des Halbleiterkörpers - zu lenken.

Gemäß zumindest einer Ausführungsform der Halbleitervorrichtung ist der Halbleiterkörper in der Montageebene des Halbleiterkörpers zwischen Pumpstrahlungsquelle und optischem Element angeordnet. Das heißt Pumpstrahlung läuft über den Halbleiterkörper hinweg, bevor sie auf die Strahlungsdurchtrittsfläche des Halbleiterkörpers gelenkt wird. Beispielsweise ist es möglich, dass Pumpstrahlungsquelle, Halbleiterkörper und optisches Element in dieser Reihenfolge entlang einer geraden Linie angeordnet sind.

Gemäß zumindest einer Ausführungsform der Halbleitervorrichtung umfasst die Halbleitervorrichtung einen Resonatoraufsatz, der der Montageebene des Halbleiterkörpers in einer Hauptabstrahlrichtung des Halbleiterkörpers nachgeordnet ist. Der Resonatoraufsatz ist dabei auch der Strahlungsdurchtrittsfläche des Halbleiterkörpers in einer Hauptabstrahlrichtung des Halbleiterkörpers nachgeordnet.

Der Resonatoraufsatz umfasst beispielsweise einen zweiten Träger, auf dem ein Resonatorspiegel befestigt ist. Der Resonatoraufsatz ist vorzugsweise parallel oder im Wesentlichen parallel zur Montageebene des Halbleiterkörpers über der Montageebene des Halbleiterkörpers angeordnet.

Der Resonatoraufsatz umfasst ferner vorzugsweise ein Umlenkelement. Bei dem Umlenkelement kann es sich beispielsweise um einen Umlenkspiegel handeln. Vom Halbleiterkörper im Betrieb emittierte elektromagnetische Strahlung trifft zunächst auf das Umlenkelement und von dort auf den Resonatorspiegel. Vom Resonatorspiegel wird die Laserstrahlung wiederum auf das Umlenkelement zurückgeworfen, das die Strahlung durch die Strahlungsdurchtrittsfläche in den Halbleiterkörper lenkt. Der Halbleiterkörper umfasst beispielsweise eine reflektierende Schichtenfolge, zum Beispiel einen Bragg-Spiegel, der einen weiteren Resonatorspiegel des derart gebildeten Laserresonators bildet.

Gemäß zumindest einer Ausführungsform ist der Resonatoraufsatz mittels eines Beabstandungselements von der Montageebene des Halbleiterkörpers beabstandet. Das Beabstandungselement ist zum Beispiel auf dem ersten Träger befestigt. Auf dem Beabstandungselement ist der Resonatoraufsatz befestigt. Vorzugsweise umfasst die Halbleitervorrichtung zumindest zwei Beabstandungselemente.

Gemäß zumindest einer Ausführungsform umfasst das Beabstandungselement ein optisches Element oder das Beabstandungselement ist aus einem optischen Element gebildet. Beispielsweise kann das Beabstandungselement dabei das optische Element umfassen oder aus dem optischen Element bestehen, das geeignet ist, Pumpstrahlung auf die Strahlungsdurchtrittsfläche des Halbleiterkörpers zu lenken.

Ferner ist es jedoch auch möglich, dass Beabstandungselemente der Halbleitervorrichtung andere optische Funktionen ausüben. Beispielsweise kann eines der Beabstandungselemente geeignet sein, die Richtung der Pumpstrahlung zu verändern, so dass die Pumpstrahlung nach Durchlauf des Beabstandungselements von der Montageebene des Halbleiterkörpers weggerichtet ist.

Gemäß zumindest einer Ausführungsform der Halbleitervorrichtung umfasst der Resonatoraufsatz ein frequenzkonvertierendes Element. Bei dem frequenzkonvertierenden Element handelt es sich vorzugsweise um einen optisch nicht-linearen Kristall. Vorzugsweise ist das frequenzkonvertierende Element auf den Träger aufgebracht. Das frequenzkonvertierende Element ist vorzugsweise zur Frequenzvervielfachung, beispielsweise zur Frequenzverdoppelung eines Teils der durch das frequenzkonvertierende Element tretenden elektromagnetischen Strahlung geeignet.

Gemäß zumindest einer Ausführungsform umfasst der Resonatoraufsatz ein Heizelement. Das Heizelement ist vorzugsweise zum Aufheizen des frequenzkonvertierenden Elements auf eine vorgebbare Temperatur geeignet. Dazu ist das Heizelement beispielsweise thermisch leitend mit dem frequenzkonvertierenden Element verbunden. Heizelement und frequenzkonvertierendes Element können dabei in direktem Kontakt zueinander stehen. Es ist aber auch möglich, dass Wärme vom Heizelement über ein Wärmeleitelement - zum Beispiel den zweiten Träger - zum frequenzkonvertierenden Element geleitet wird.

Gemäß zumindest einer Ausführungsform der Halbleitervorrichtung ist das Heizelement durch eine Metallbeschichtung gebildet. Bevorzugt umfasst der zweite Träger zumindest eine Metallbeschichtung, mittels der die Temperatur des Resonatoraufsatzes erhöht und/oder ermittelt werden kann. Vorzugsweise kann die Temperatur des Resonatoraufsatzes mittels der Metallbeschichtung erhöht und ermittelt werden. Bei der Metallbeschichtung handelt es sich vorzugsweise um eine strukturierte Metallbeschichtung. Zum Beispiel ist die Metallbeschichtung mäanderartig ausgebildet oder die Metallbeschichtung weist eine Mehrzahl von Ausnehmungen auf. Die Metallbeschichtung enthält oder besteht vorzugsweise aus zumindest einem der folgenden Metalle: Platin, Gold.

Die Metallbeschichtung weist vorzugsweise ferner Kontaktstellen auf, mittels derer die Metallbeschichtung elektrisch kontaktierbar ist. Durch Bestromen der Metallbeschichtung kann die Temperatur des Resonatoraufsatzes gezielt erhöht werden. Auf diese Weise kann das Frequenzkonversionselement beispielsweise auf eine vorgebbare Betriebstemperatur aufgeheizt werden. Ferner kann - beispielsweise durch die Messung des temperaturabhängigen elektrischen Widerstands der Metallbeschichtung - die Temperatur der Metallbeschichtung und damit die Temperatur des Resonatoraufsatzes und des Frequenzkonversionselements ermittelt werden.

Vorzugsweise ist die Metallbeschichtung dazu mit einer Steuervorrichtung verbunden, die geeignet ist, eine von außen vorgebbare Temperatur der Metallbeschichtung einzustellen und zu regeln. Die Steuervorrichtung kann beispielsweise einen Mikrocontroller umfassen. Die Steuervorrichtung kann auf dem Anschlussträger - dem ersten Träger - der Halbleitervorrichtung angeordnet sein. Es ist aber auch möglich, dass die Steuervorrichtung außerhalb der Halbleitervorrichtung angeordnet ist und elektrisch leitend mit der Halbleitervorrichtung verbunden ist.

Gemäß zumindest einer Ausführungsform der Halbleitervorrichtung ist der Resonatoraufsatz elektrisch leitend mit dem Anschlussträger verbunden. Beispielsweise kann der Resonatoraufsatz mittels Anschlussdrähten - zum Beispiel Bonddrähten - mit dem Anschlussträger verbunden sein. Die Anschlussdrähte sind geeignet, die Kontaktstellen des Heizelements elektrisch leitend mit dem Anschlussträger zu verbinden.

Gemäß zumindest einer Ausführungsform der Halbleitervorrichtung beträgt bei Betrieb der Halbleitervorrichtung die Temperatur - beispielsweise die mittlere Temperatur - des Resonatoraufsatzes wenigstens 10 K mehr als die Temperatur - beispielsweise die mittlere Temperatur - des Anschlussträgers. Beispielsweise wird die mittlere Temperatur des Anschlussträgers - zum Beispiel mittels eines aktiven oder passiven Kühlelements - auf maximal 35° C, vorzugsweise maximal 30° C geregelt. Die mittlere Temperatur des Resonatoraufsatz wird vorzugsweise mittels des Heizelements bei wenigstens 45° C, vorzugsweise wenigstens 50° C gehalten. Resonatoraufsatz und Anschlussträger sind dabei thermisch weitgehend voneinander isoliert. Dies kann beispielsweise durch thermisch schlecht leitende Beabstandungselemente erreicht sein, die zum Beispiel ein Glas enthalten können.

Es wird ferner eine optische Projektionsvorrichtung mit einer optisch pumpbaren Halbleitervorrichtung angegeben, wie sie in Verbindung mit zumindest einer der oben aufgeführten Ausführungsformen der Halbleitervorrichtung beschrieben ist. Gemäß zumindest einer Ausführungsform umfasst die optische Projektionsvorrichtung beispielsweise eine Ansteuervorrichtung, die zur Ansteuerung der optisch pumpbaren Halbleitervorrichtung geeignet ist. Die optische Projektionsvorrichtung kann ferner beispielsweise ein bildgebendes Element sowie eine Projektionsoptik umfassen.

Im Folgenden wird die hier beschriebene Halbleitervorrichtung anhand von Ausführungsbeispielen und den dazugehörigen Figuren näher erläutert.
- Figur 1A: zeigt die Pumpeinheit einer hier beschriebenen Halbleitervorrichtung gemäß einem ersten Ausführungsbeispiel der Halbleitervorrichtung in einer schematischen Schnittdarstellung.
- Figur 1B: zeigt die Pumpeinheit der optisch pumpbaren Halbleitervorrichtung gemäß dem ersten Ausführungsbeispiel in einer schematischen Draufsicht.
- Figur 1C: zeigt eine optisch pumpbare Halbleitervorrichtung gemäß einem zweiten Ausführungsbeispiel in einer schematischen Schnittansicht.
- Figur 1D: zeigt die optisch pumpbare Halbleitervorrichtung gemäß dem zweiten Ausführungsbeispiel in einer schematischen Perspektivdarstellung.
- Figur 1E: zeigt die Pumpeinheit einer optisch pumpbaren Halbleitervorrichtung gemäß dem ersten oder dem zweiten Ausführungsbeispiel in einer schematischen Schnittdarstellung vor dem Aufbringen passiver optischer Elemente.
- Figur 1F: zeigt die Pumpeinheit einer optisch pumpbaren Halbleitervorrichtung gemäß dem ersten oder dem zweiten Ausführungsbeispiel in einer schematischen Draufsicht.
- Figur 2A: zeigt eine schematische Perspektivdarstellung einer Pumpeinheit der hier beschriebenen Halbleitervorrichtung gemäß einem dritten Ausführungsbeispiel.
- Figur 2B: zeigt die oberflächenemittierende Halbleitervorrichtung gemäß dem dritten Ausführungsbeispiel in einer schematischen Perspektivdarstellung unter einem ersten Winkel betrachtet.
- Figur 2C: zeigt die oberflächenemittierende Halbleitervorrichtung gemäß dem dritten Ausführungsbeispiel unter einem zweiten Winkel betrachtet.
- Figur 2D: zeigt die optisch pumpbare Halbleitervorrichtung gemäß dem dritten Ausführungsbeispiel in einer schematischen Draufsicht.
- Figuren 2E und 2F: zeigen schematische Seitenansichten der optisch pumpbaren Halbleitervorrichtung gemäß dem dritten Ausführungsbeispiel aus unterschiedlichen Betrachtungsrichtungen.
- Figur 2G: zeigt die Pumpeinheit der optisch pumpbaren Halbleitervorrichtung gemäß dem dritten Ausführungsbeispiel vor Bestückung mit passiven optischen Elementen in einer schematischen Seitenansicht, Figur 2H zeigt die zugehörige schematische Draufsicht.
- Figuren 3A, 3B, 3C und 3D: zeigen in einer schematischen Draufsicht die Herstellung von Resonatoraufsätzen 40 für ein Ausführungsbeispiel der hier beschriebenen Halbleitervorrichtung.
- Figur 3E: zeigt in einer schematischen Seitenansicht einen derart hergestellten Resonatoraufsatz 40.
- Figur 3F: zeigt eine schematische Draufsicht auf einen derart hergestellten Resonatoraufsatz 40.
- In Verbindung mit den Figuren 4A bis 4D: ist ein Herstellungsverfahren zur Herstellung der Resonatorspiegel 31 beschreiben, wie sie für ein Ausführungsbeispiel der hier beschreiben Halbleitervorrichtung zum Einsatz kommen.
- Figur 5: zeigt einen Anschlussträgerverbund 50 mit einer Vielzahl von matrixartig angeordneten Anschlussträgern 14 wie sie beispielsweise für die in Verbindung mit den Figuren 1 und 2 beschriebenen Ausführungsbeispiele der hier beschriebenen Halbleitervorrichtung zum Einsatz kommen.
- Figur 6A: zeigt eine schematische Draufsicht auf einen Anschlussträgerverbund 50 mit einer Vielzahl von matrixartig angeordneten Anschlussträgern 14, wie sie beispielsweise für die in Verbindung mit den Figuren 1 und 2 beschriebenen Ausführungsbeispielen der hier beschriebenen Halbleitervorrichtung zum Einsatz kommen.
- Figur 6B: zeigt eine schematische Draufsicht auf die Rückseite des Anschlussträgers 50.
- Figur 6C: zeigt eine schematische Seitenansicht des Anschlussträgers 50.
- Figur 6D: zeigt eine schematische Draufsicht auf einen Anschlussträger 14 des Anschlussträgerverbundes 50.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

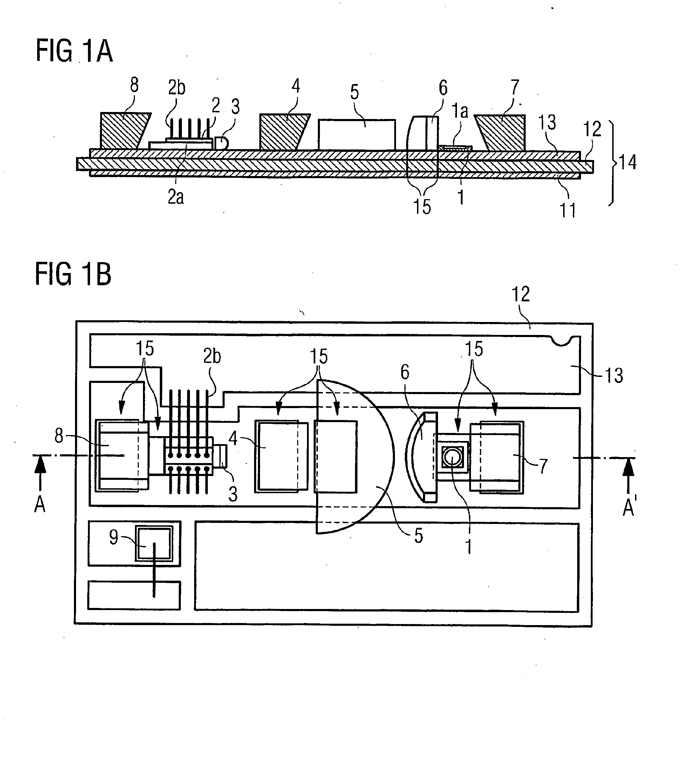

Figur 1A zeigt die Pumpeinheit einer hier beschriebenen Halbleitervorrichtung gemäß einem ersten Ausführungsbeispiel der Halbleitervorrichtung in einer schematischen Schnittdarstellung.

Die Pumpeinheit umfasst einen Anschlussträger 14. Die Grundfläche der hier beschriebenen oberflächenemittierenden Halbleiterlaservorrichtungen - das heißt die Grundfläche des Anschlussträgers 14 - beträgt vorzugsweise zwischen 30 und 150 mm². Der Anschlussträger 14 umfasst im hier gezeigten Ausführungsbeispiel einen Grundkörper 12, eine Unterseitenmetallisierung 11 sowie eine strukturierte Oberseitenmetallisierung 13. Bei dem Anschlussträger 14 handelt es sich vorzugsweise um einen Direct Bonded Copper (DBC) Verbundwerkstoff. Der Grundkörper 12 besteht beispielsweise aus einem keramischen Material wie einem AlN. Die Dicke des Grundkörpers 12 beträgt vorzugsweise zwischen 0,2 und 0,5 mm, besonders bevorzugt 0,38 mm. Die Oberseitenmetallisierung 13 sowie die Unterseitenmetallisierung 11 bestehen beispielsweise aus Kupfer und weisen eine Dicke zwischen 0,1 und 0,3 mm, vorzugsweise 0,2 mm auf. Vorteilhaft weist Kupfer eine hohe Wärmeleitfähigkeit von zirka 400 Watt pro Meter Kelvin auf. Durch den Verbund mit dem AlN-Grundkörper 12 wird der effektive thermische Ausdehnungskoeffizient des Anschlussträgers 14 an seiner Oberfläche gesenkt. Dies kommt der Montage von Halbleiterkörpern mit geringem Ausdehnungskoeffizienten zugute.

Die strukturierte Oberseitenmetallisierung 13 bildet Leiterbahnen, über die auf dem Anschlussträger 14 befestigte, aktive Halbleiterbauelemente elektrisch kontaktierbar sind. Alternativ zum in Verbindung mit Figur 1A beschriebenen Anschlussträger 14 ist es auch möglich, einen Anschlussträger 14 zu verwenden, der einen keramischen Grundkörper 12 umfasst, der beispielsweise aus AlN besteht. Auf die Oberseite des Grundkörpers 12 kann dann eine Oberseitenmetallisierung 13 aufgebracht sein. Dazu ist beispielsweise eine Goldmetallisierung mittels einer Maske direkt auf den Grundkörper 12 - zum Beispiel mittels Sputtern oder Aufdampfen - strukturiert. Die Dicke der Goldschicht beträgt dabei maximal 1 µm, vorzugsweise maximal 500 nm. Ein solcher Anschlussträger zeichnet sich gegenüber einem DBC-Anschlussträger durch eine besonders glatte Oberfläche aus. Die Dicke des Grundkörpers 12 beträgt dabei vorzugsweise maximal 1 mm, besonders bevorzugt maximal 0,7 mm. Metallische Sperren - beispielsweise für ein Lotmaterial - die zum Beispiel aus Platin oder NiCr bestehen können oder zumindest eines dieser Materialen enthalten, können direkt auf den Anschlussträger 14 durch Aufdampfen oder Sputtern abgeschieden und strukturiert werden.

Auf den Anschlussträger 14 ist ein oberflächenemittierender Halbleiterkörper 1 aufgebracht. Der oberflächenemittierende Halbleiterkörper 1 ist beispielsweise auf den Anschlussträger 14 aufgelötet oder aufgeklebt. Vorzugsweise ist der oberflächenemittierende Halbleiterköper 1 mittels einer Lotverbindung auf dem Anschlussträger 14 befestigt. Dazu eignet sich insbesondere ein Dünnschichtlot. Das heißt der oberflächenemittierende Halbleiterkörper 1 ist mittels eines Lots, das durch Sputtern oder Aufdampfen abgeschieden ist, befestigt. Das Lot enthält oder besteht vorzugsweise aus wenigstens einem der folgenden Materialien: AuSn, Sn, SnAg, In, InSn. Vorzugsweise beträgt die Dicke der Lotschicht zwischen 1 und 5 µm.

Der oberflächenemittierende Halbleiterkörper 1 umfasst eine reflektierende Schichtenfolge und eine strahlungserzeugende Schichtenfolge. Bei der reflektierenden Schichtenfolge handelt es sich vorzugsweise um eine reflektierende Metallschicht, einem Bragg-Spiegel oder eine Kombination dieser reflektierenden Schichten. Vorzugsweise handelt es sich bei der reflektierenden Schichtenfolge um einen Bragg-Spiegel der eine Mehrzahl von Halbleiterschichtenpaaren mit vorteilhaft hohem Brechungsindexunterschied aufweist. Bevorzugt umfasst der Bragg-Spiegel eine Abfolge von 20 bis 30 oder mehr Halbleiterschichtenpaare, woraus eine besonders hohe Reflektivität des Spiegels von 99,9 % oder höher resultiert. Mit Vorteil ist der Bragg-Spiegel gemeinsam mit den übrigen Halbleiterschichten des Halbleiterkörpers 1 epitaktisch hergestellt. Der Bragg-Spiegel ist vorzugsweise auf der dem Anschlussträger 14 zugewandten Seite des Halbleiterkörpers 1 angeordnet.

Die strahlungserzeugende Schichtenfolge des Halbleiterkörpers umfasst einen aktiven Bereich mit einem pn-Übergang und/oder einer Einfachquantentopfstruktur und/oder vorzugsweise einer Mehrfachquantentopfstruktur - besonders bevorzugt einer undotierten Mehrfachquantentopfstruktur -, die zur Strahlungserzeugung geeignet ist. Die Bezeichnung Quantentopfstruktur umfasst im Rahmen der Beschreibung insbesondere auch jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Vorzugsweise basiert die strahlungsemittierende Schichtenfolge auf einem III-V-Verbindungshalbleitermaterial. Das heißt die strahlungsemittierende Schichtenfolge umfasst mindestens eine Schicht, die aus einem III-V-Verbindungshalbleitermaterial besteht. Bevorzugt basiert die strahlungsemittierende Schichtenfolge auf einem Nitrid-, Phosphid- oder besonders bevorzugt Arsenid-Verbindungshalbleiter.

"Auf Nitrid-Verbindungshalbleitern basierend" bedeutet im vorliegenden Zusammenhang, dass die strahlungsemittierende Schichtenfolge oder zumindest eine Schicht davon ein Nitrid-V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘn-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass die strahlungsemittierende Schichtenfolge oder zumindest eine Schicht davon vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass die strahlungsemittierende Schichtenfolge oder zumindest eine Schicht davon vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des.Kristallgitters (Al, Ga, In, As), auch wenn diese teilweise durch geringe Mengen weiterer Stoffe ersetzt sein können.

Diese Materialien zeichnen sich durch vereinfacht erreichbare hohe interne Quanteneffizienzen aus und eignen sich für Strahlung vom ultravioletten, insbesondere Nitrid-basiertes Verbindungshalbleitermaterial, über den sichtbaren, insbesondere Phosphid-basierte Verbindungshalbleitermaterialien, bis in den infraroten Spektralbereich, insbesondere Arsenid-basierte Verbindungshalbleitermaterialien.

Bevorzugt basiert die strahlungserzeugende Schichtenfolge des Halbleiterkörpers auf einem Arsenid-Verbindungshalbleitermaterial. Strahlung im infraroten Spektralbereich, insbesondere im Wellenbereich zwischen 800 nm und 1100 nm, kann in diesem Materialsystem besonders effizient erzeugt werden. Beispielsweise enthält der Träger Galliumarsenid und die strahlungsemittierende Schichtenfolge oder zumindest eine Schicht davon basiert auf dem Materialsystem AlₙGaₘIn₁₋ₙ₋ₘAs mit 0 ≤ n ≤ 1, 0 ≤ m ≤ 1 und n+m ≤ 1.

Weiter ist auf dem Anschlussträger 14 eine Pumpstrahlungsquelle 2 angeordnet. Die Pumpstrahlungsquelle 2 umfasst beispielsweise einen kantenemittierenden Halbleiterlaser sowie ein Wärmeelement 2a. Das Wärmeleitelement 2a besteht vorzugsweise aus einem gut wärmeleitenden Material, wie beispielsweise Diamant, Aluminiumnitrid oder Siliziumcarbid oder enthält zumindest eines dieser Materialien. Die Pumpstrahlungsquelle 2 ist mittels Anschlussdrähten 2b elektrisch leitend an den Anschlussträger 14 angeschlossen. Vorzugsweise ist die Pumpstrahlungsquelle 2 mittels einer Lotverbindung auf dem Anschlussträger 14 befestigt. Dazu eignet sich insbesondere ein Dünnschichtlot. Das heißt die Pumpstrahlungsquelle 2 ist mittels eines Lots, das durch Sputtern oder Dampfen abgeschieden ist, befestigt. Das Lot enthält oder besteht vorzugsweise aus wenigstens einem der folgenden Materialien: AuSn, Sn, SnAg, In, InSn. Vorzugsweise beträgt die Dicke der Lotschicht zwischen ein und fünf Mikrometer.

Der Pumpstrahlungsquelle 2 ist eine Linse 3 nachgeordnet. Die Linse 3 dient beispielsweise zur fast axis collimination (FAC) der von der Pumpstrahlquelle 2 emittierten Pumpstrahlung 17. Die Linse 3 weist dazu beispielsweise eine asphärisch gekrümmte Strahlungsaustrittsfläche auf und kann aus einem hochbrechenden Material wie GaP bestehen.

Der Linse 3 ist in Hauptabstrahlrichtung der Pumpstrahlquelle 2 ein weiteres optisches Element 4 nachgeordnet. Das optische Element 4 ist vorzugsweise zur Brechung der durchtretenden Pumpstrahlung geeignet. Beispielsweise ist das optische Element 4 geeignet, die Pumpstrahlung 17 vom Anschlussträger 14 weg zu brechen oder zu lenken. Das optische Element 4 enthält vorzugsweise ein Glas.

Dem optischen Element 4 sind eine Zylinderlinse 5 sowie eine sphärische Linse 6 nachgeordnet. Die Linsen 5, 6 dienen zur slow axis collimination (SAC) und/oder fast axis collimination der durchtretenden Pumpstrahlung. Beispielsweise können die beiden Linsen 5, 6 auch durch eine einzige Zylinderlinse mit asphärisch gekrümmter Strahlungsdurchtrittsfläche ersetzt sein. Von den Linsen 5, 6 gelangt die Pumpstrahlung auf das Umlenkelement 7.

Das Umlenkelement 7 enthält beispielsweise ein Glas, wobei die dem oberflächenemittierenden Halbleiterkörper zugewandte Fläche für die Pumpstrahlung hochreflektierend beschichtet ist. Das Umlenkelement 7 lenkt die auftreffende Pumpstrahlung auf die Strahlungsdurchtrittsfläche 1a des oberflächenemittierenden Halbleiterkörper 1, derart, dass Pumpstrahlung 17 vorzugsweise unter einem spitzen Winkel auf die Strahlungsdurchtrittsfläche 1a trifft.

Weiter kann ein Beabstandungselement 8 auf dem Träger 14 angeordnet sein. Bei den Elementen 8, 4, 7 kann es sich um Elemente handeln, die gleichartig geformt sind und aus dem gleichen Material bestehen. Sie unterscheiden sich dann lediglich durch reflektierend, entspiegelt, oder unbeschichtet ausgebildete Oberflächen sowie ihre Orientierung auf dem Anschlussträger 14.

Die Figur 1B zeigt die Pumpeinheit der optisch pumpbaren Halbleitervorrichtung gemäß dem ersten Ausführungsbeispiel in einer schematischen Draufsicht.

Wie der Figur 1B zu entnehmen ist, ist auf dem Anschlussträger 14 ferner ein Temperatursensor 9 aufgebracht, der beispielsweise einen NTC-Widerstand umfasst. Mittels des Temperatursensors 9 kann die mittlere Temperatur des Anschlussträgers 14 ermittelt werden. Abhängig von der mittleren Temperatur des Anschlussträgers 14 kann beispielsweise mit Hilfe eines thermoelektrischen Kühlers, der etwa an der Unterseite des Anschlussträgers 14 angeordnet sein kann, eine Betriebstemperatur der Pumpeinheit eingestellt werden. Bevorzugt beträgt die Betriebstemperatur der Pumpeinheit zwischen 20 und 35° C, besonders bevorzugt 25° C.

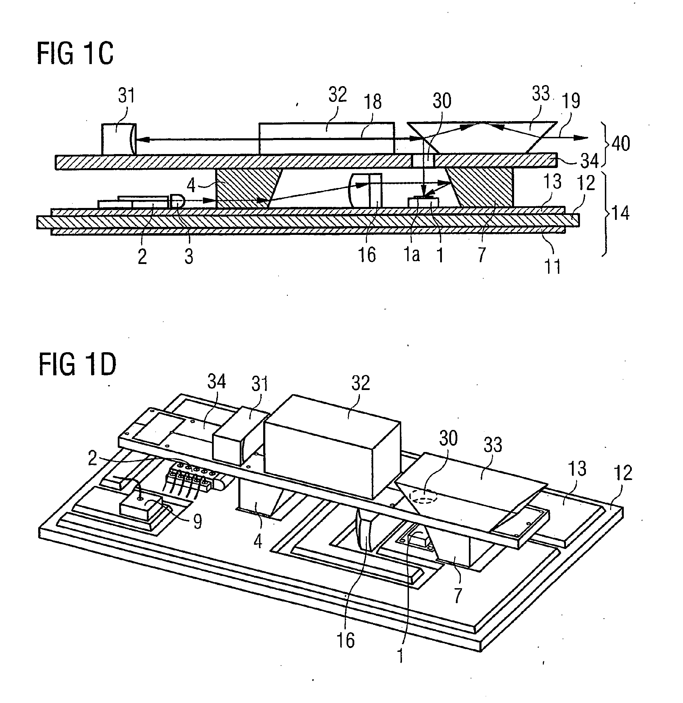

Figur 1C zeigt eine optisch pumpbare Halbleitervorrichtung gemäß einem zweiten Ausführungsbeispiel in einer schematischen Schnittansicht.

Der Pumpeinheit ist dabei in Hauptabstrahlrichtung des oberflächenemittierenden Halbleiterkörpers 1 ein Resonatoraufsatz 40 nachgeordnet.

Die Pumpeinheit umfasst einen Anschlussträger 14, wie er weiter oben beschrieben ist. Die Pumpeinheit umfasst ferner eine Pumpstrahlungsquelle 2, der eine FAC-Linse 3 nachgeordnet ist. Die Pumpstrahlung tritt von der FAC-Linse 3 durch ein optisches Element 4, das die Pumpstrahlung 17 vom Anschlussträger 14 wegbricht. Nachfolgend tritt die Pumpstrahlung durch eine asphärische Linse 16, die zur Kolliminierung der Pumpstrahlung vorgesehen ist. Von dort trifft die Pumpstrahlung auf ein Umlenkelement 7, das die Pumpstrahlung auf die Strahlungsdurchtrittsfläche 1a des oberflächenemittierenden Halbleiterkörpers 1 lenkt. Die Pumpstrahlung 17 regt im Halbleiterkörper 1 die Erzeugung von Laserstrahlung 18 der Grundfrequenz an. Die Laserstrahlung 18 der Grundfrequenz tritt durch eine Ausnehmung 30, die sich im Träger 34 des Resonatoraufsatzes 40 befindet, in den Resonatoraufsatz 40 ein. Von einem Umlenkelement 33, das beispielsweise durch ein Dove-Prisma gebildet ist, wird die Laserstrahlung in Richtung eines Resonatorspiegels 31 gelenkt. Im Laserresonator ist vorzugsweise ein optisch nicht-linearer Kristall 32 angeordnet, der beispielsweise zur Frequenzvervielfachung der durchtretenden Laserstrahlung dient. Ein Grossteil der derart erzeugten konvertierten Strahlung 19 wird durch das Umlenkelement 33 aus der Halbleitervorrichtung ausgekoppelt.

Bevorzugt umfasst der optisch nicht-lineare Kristall 32 zumindest einen der folgenden Kristalle: Lithiumtriborat zum Beispiel LiB₃O₅ (LBO), Wismuttriborat zum Beispiel BiB₃O₆ (BiBO), Kaliumtitanylphosphat KTiOPO₄ (KTP), magnesiumoxiddotiertes kongruentes Lithiumniobat zum Beispiel MgO:LiNbO₃ (MgO:LN), magnesiumoxiddotiertes stöchiometrisches Lithiumniobat zum Beispiel MgO:s-LiNbO₃ (MgO:SLN), magnesiumoxiddotiertes stöchiometrisches Lithiumtantalat zum Beispiel MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄).

Bevorzugt ist der optisch nicht-lineare Kristall zur Frequenzverdoppelung der ihn durchtretenden Strahlung geeignet.

Ferner kann im Laserresonator ein frequenzselektives Element wie beispielsweise ein Etalon oder ein doppelbrechendes Filter angeordnet sein, das einen spektral stabilen und schmalbandigen Betrieb des Lasers vorteilhaft erleichtert.

Die Figur 1D zeigt die optisch pumpbare Halbleitervorrichtung gemäß dem zweiten Ausführungsbeispiel in einer schematischen Perspektivdarstellung.

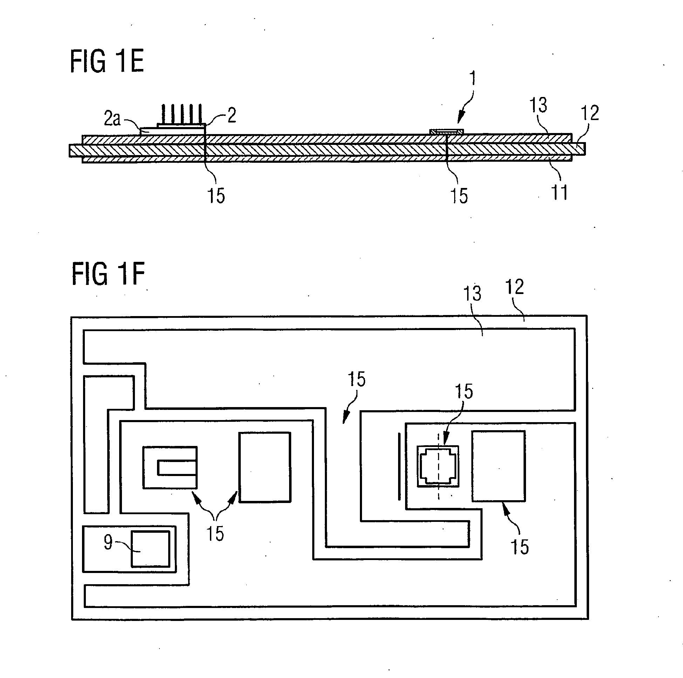

Figur 1E zeigt die Pumpeinheit einer optisch pumpbaren Halbleitervorrichtung gemäß dem ersten oder dem zweiten Ausführungsbeispiel in einer schematischen Schnittdarstellung vor dem Aufbringen passiver optischer Elemente. Figur 1F zeigt die zugehörige schematische Draufsicht.

Wie den Figuren 1E und 1F zu entnehmen ist, weist der Anschlussträger 14 Nebenjustagemarken 15 auf. Bei den Nebenjustagemarken 15 handelt es sich beispielsweise um Ablagestrukturen, die als fototechnisch strukturierte Dünnschichten ausgeführt sind.

Die Nebenjustagemarken dienen als Orientierungshilfen für ein Bildverarbeitungssystem, mittels dem die Ablagepositionen für die einzelnen Elemente der Halbleitervorrichtung auf dem Anschlussträger 14 ermittelt werden. Die Ablagegenauigkeit für die einzelnen Elemente beträgt dabei vorzugsweise zwischen +/- 5 µm bis +/- 50 µm. Besonders bevorzugt beträgt die Ablagegenauigkeit wenigstens +/- 10 µm.

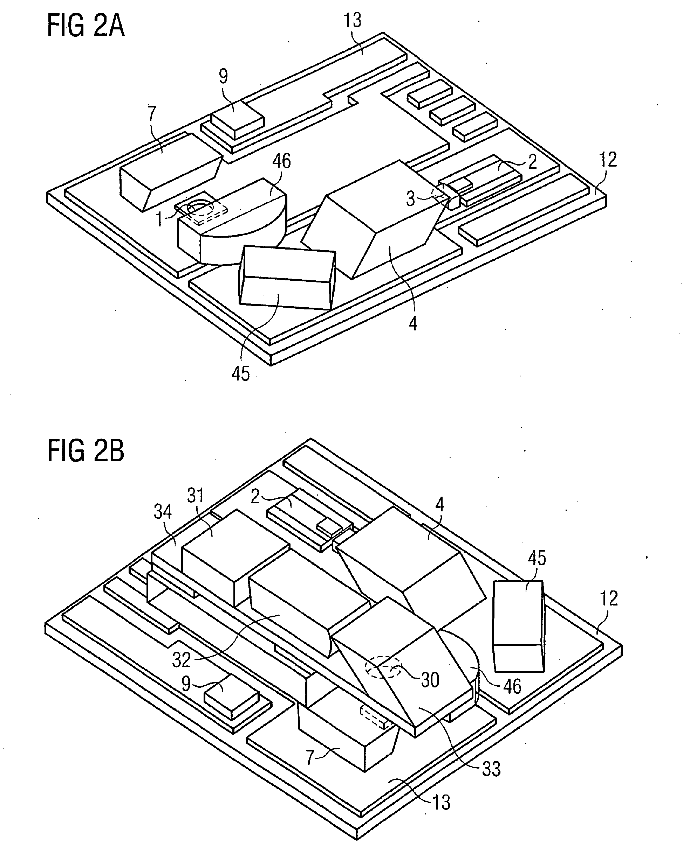

Figur 2A zeigt eine schematische Perspektivdarstellung einer Pumpeinheit der hier beschriebenen Halbleitervorrichtung gemäß einem dritten Ausführungsbeispiel. In diesem Ausführungsbeispiel ist die Grundfläche der Halbleitervorrichtung, das heißt die Fläche des Anschlussträgers 14 gegenüber den ersten beiden Ausführungsbeispielen um zirka 30 % reduziert. Im Gegensatz zum in Verbindung mit den Figuren 1A bis 1F beschriebenen Ausführungsbeispiel sind Pumpstrahlquelle 2, oberflächenemittierender Halbleiterkörper 1 sowie Umlenkoptik 7 hier nicht entlang einer geraden Linie angeordnet.

Pumpstrahlung tritt von der Pumpstrahlungsquelle 2 zunächst durch eine FAC-Linse 3. Von dort tritt die Pumpstrahlung durch ein optisches Element 4, das beispielsweise durch ein Durchstrahlprisma oder einen Parallelepiped gebildet ist. Vom Umlenkspiegel 45 wird die Pumpstrahlung dann auf eine asphärische Zylinderlinse 46 gerichtet, die die Pumpstrahlung weiter kolliminiert. Von dort trifft die Pumpstrahlung auf die Umlenkoptik 7, welche die Pumpstrahlung auf die Strahlungsdurchtrittsfläche des oberflächenemittierenden Halbleiterkörpers 1 lenkt.

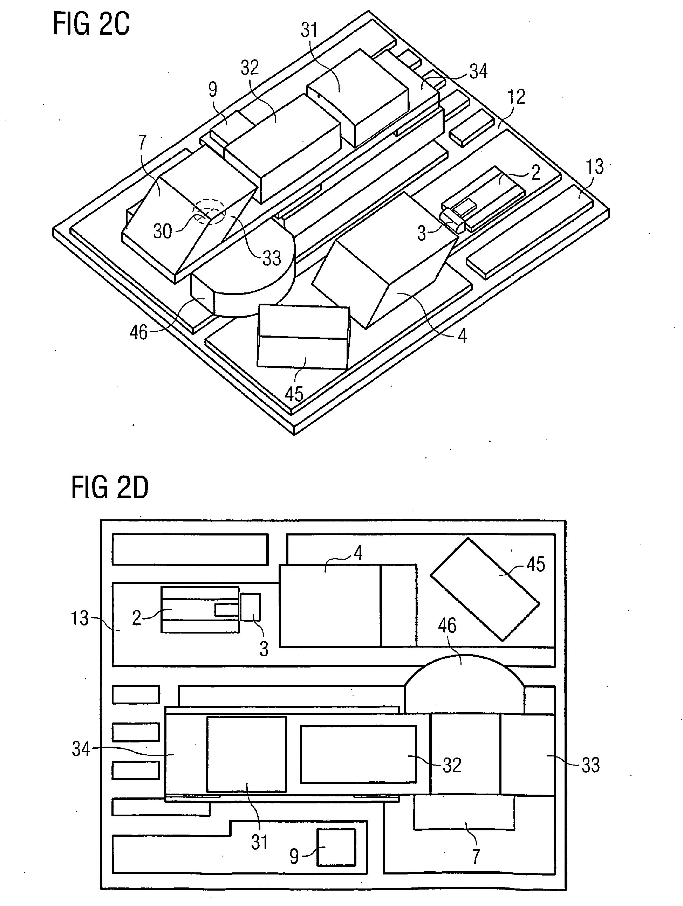

Figur 2B zeigt die oberflächenemittierende Halbleitervorrichtung gemäß dem dritten Ausführungsbeispiel in einer schematischen Perspektivdarstellung unter einem ersten Winkel betrachtet. Die Figur 2C zeigt die oberflächenemittierende Halbleitervorrichtung gemäß dem dritten Ausführungsbeispiel unter einem zweiten Winkel betrachtet. Im Gegensatz zu den in Verbindung mit den Figuren 1A bis 1F beschriebenen Ausführungsbeispielen ist die Umlenkoptik 33 im dritten Ausführungsbeispiel nicht durch ein Dove-Prisma sondern durch einen Parallelepiped gebildet.

Figur 2D zeigt die optisch pumpbare Halbleitervorrichtung gemäß dem dritten Ausführungsbeispiel in einer schematischen Draufsicht.

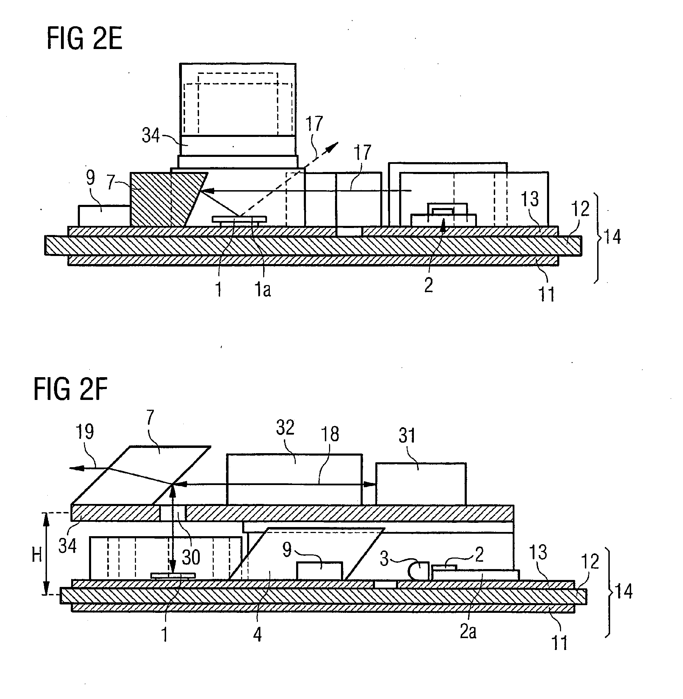

Die Figuren 2E und 2F zeigen schematische Seitenansichten der optisch pumpbaren Halbleitervorrichtung gemäß dem dritten Ausführungsbeispiel aus unterschiedlichen Betrachtungsrichtungen.

Wie der Figur 2E zu entnehmen ist, trifft bei der Halbleitervorrichtung gemäß dem zweiten Ausführungsbeispiel keine Pumpstrahlung, die gegebenenfalls an der Strahlungsdurchtrittsfläche 1a des oberflächenemittierenden Halbleiterkörpers 1 reflektiert wird, in den optisch nicht-linearen Kristall. Auf diese Weise kann vorteilhaft eine besonders stabile Frequenzkonversion erfolgen, da der optisch nicht-lineare Kristall 32 durch die reflektierte Pumpstrahlung 17 nicht aufgeheizt werden kann.

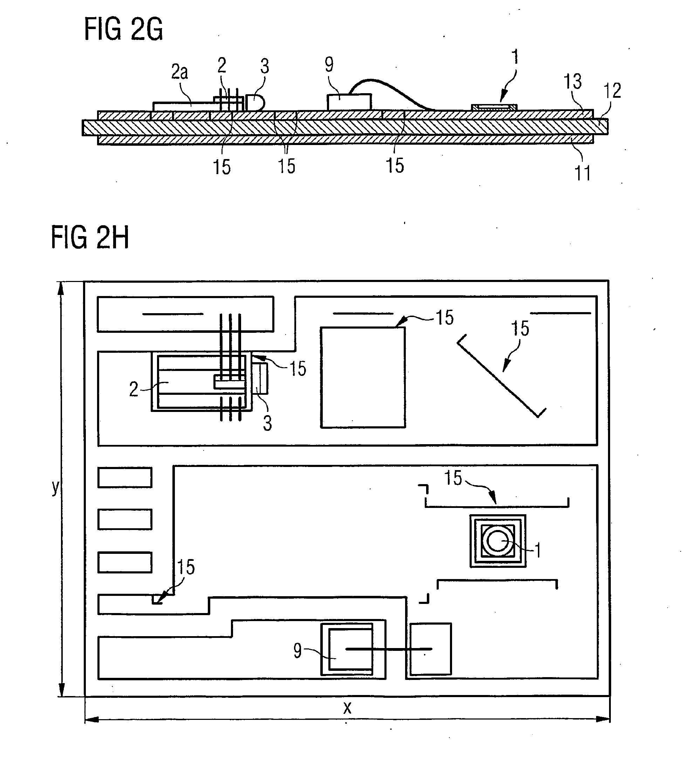

Die Figur 2G zeigt die Pumpeinheit der optisch pumpbaren Halbleitervorrichtung gemäß dem dritten Ausführungsbeispiel vor Bestückung mit passiven optischen Elementen in einer schematischen Seitenansicht, Figur 2H zeigt die zugehörige schematische Draufsicht. Wie den Figuren 2G und 2H zu entnehmen ist, weist der Anschlussträger 14 Nebenjustagemarken 15 auf. Das heißt es sind in den Anschlussträger 14 Ablagestrukturen 15 strukturiert, die als Orientierungshilfen für ein Bildverarbeitungssystem dienen. Bei den Nebenjustagemarken 15 handelt es sich beispielsweise um Ablagestrukturen, die als fototechnisch strukturierte Dünnschichten ausgeführt sind.

Die Nebenjustagemarken dienen als Orientierungshilfen für ein Bildverarbeitungssystem, mittels dem die Ablagepositionen für die einzelnen Elemente der Halbleitervorrichtung auf dem Anschlussträger 14 ermittelt werden. Die Ablagegenauigkeit für die einzelnen Elemente beträgt dabei vorzugsweise zwischen +/- 5 µm bis +/- 50 µm. Besonders bevorzugt beträgt die Ablagegenauigkeit wenigstens +/- 10 µm.

Beispielsweise beträgt die Breite y des Anschlussträgers 14 zwischen 9 und 13 mm, vorzugsweise zirka 10 mm. Die Länge x des Anschlussträgers 4 beträgt vorzugsweise zwischen 9 und 14 mm, beispielsweise 12 mm.

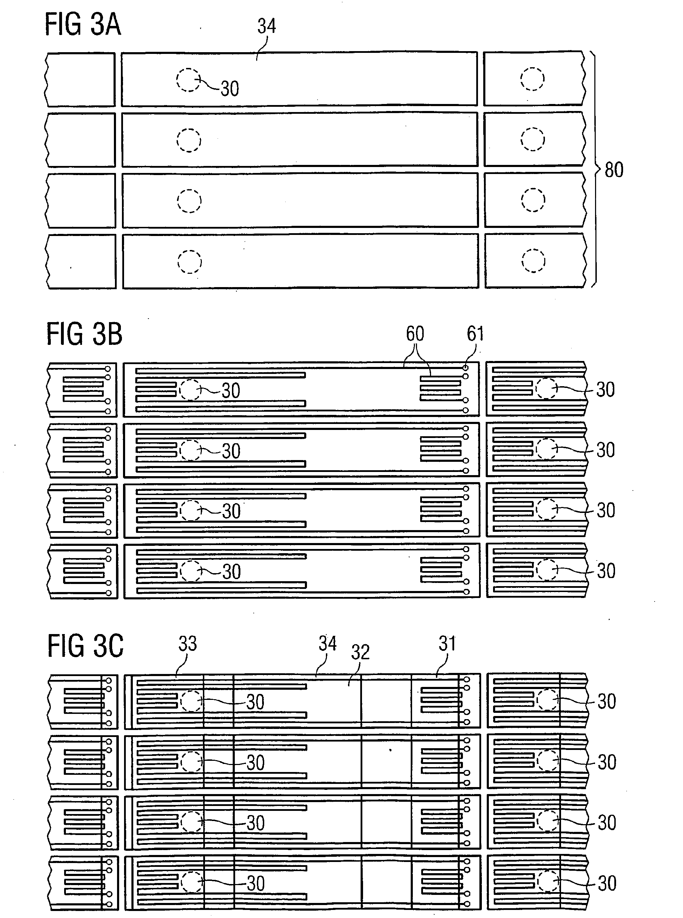

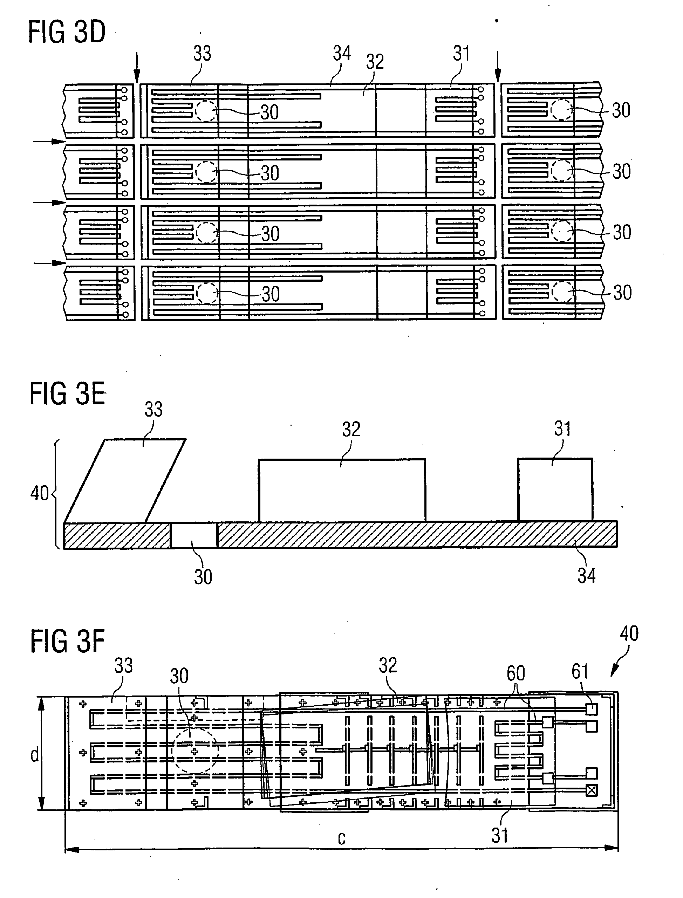

Die Figuren 3A, 3B, 3C und 3D zeigen in einer schematischen Draufsicht die Herstellung von Resonatoraufsätzen 40 für ein Ausführungsbeispiel der hier beschriebenen Halbleitervorrichtung. Die Figur 3E zeigt in einer schematischen Seitenansicht einen derart hergestellten Resonatoraufsatz 40.

In der Figur 3A ist ein Trägerverbund 80 dargestellt, der eine matrixartige Anordnung einer Vielzahl von Einzelträgerbereichen 34 umfasst. Der Trägerverbund 80 ist zum Beispiel durch einen Siliziumwafer gebildet. Beispielsweise handelt es sich dabei um einen sechs Zoll oder acht Zoll Siliziumwafer. Jeder Einzelträgerbereich 34 weist eine Ausnehmung 30 - beispielsweise eine Bohrung - auf. Die Ausnehmung 30 erlaubt den Durchtritt von Laserstrahlung in und aus dem Resonatoraufsatz 40.

In einem folgenden Verfahrensschritt (siehe Figur 3B) wird eine strukturierte Metallbeschichtung 60 auf die Einzelträgerbereiche 34 strukturiert. Die Metallbeschichtung 60 ist beispielsweise durch eine mäanderartige Platinbeschichtung gebildet, die mittels Kontaktstellen 61 elektrisch kontaktierbar ist.

Im in Verbindung mit Figur 3C beschriebenen Verfahrensschritt werden optische Elemente wie ein Umlenkspiegel 33, ein optisch nicht-linearer Kristall 32 sowie ein Resonatorspiegel 31 auf den Einzelträgerbereichen 34 angeordnet. Vorzugsweise werden die optischen Elemente im Verbund - beispielsweise als Streifen, die eine Vielzahl von Resonatorspiegeln 31 umfassen - auf dem Trägerverbund 80 angeordnet. Auf diese Weise kann gleichzeitig auf einer Vielzahl von Einzelträgerbereichen 34 jeweils eines der optischen Elemente angeordnet werden. Die optischen Elemente können beispielsweise aufgeklebt werden. Vorzugsweise werden die optischen Elemente mittels Bonden, beispielsweise anodischem Bonden, auf den Einzelträgerbereichen 34 befestigt.

In einem abschließenden Verfahrensschritt kann der Trägerverbund 80 wie in Figur 3D dargestellt entlang der dort eingezeichneten Pfeile vereinzelt werden. Dabei können auch die im Verbund angeordneten optischen Elemente vereinzelt werden. Es resultiert eine Vielzahl von Resonatoraufsätzen 40. Ein derartiger Resonatoraufsatz ist beispielsweise in Figur 3E schematisch dargestellt.

Figur 3F zeigt eine schematische Draufsicht auf den Resonatoraufsatz 40. Vorzugsweise beträgt die Länge des Resonatoraufsatzes 40 zwischen c = 8 und c = 12 mm, beispielsweise c = 10 mm. Die Breite des Resonatoraufsatzes 40 beträgt vorzugsweise zwischen d = 1, 75 mm und d = 3 mm, beispielsweise d = 2,15 mm.

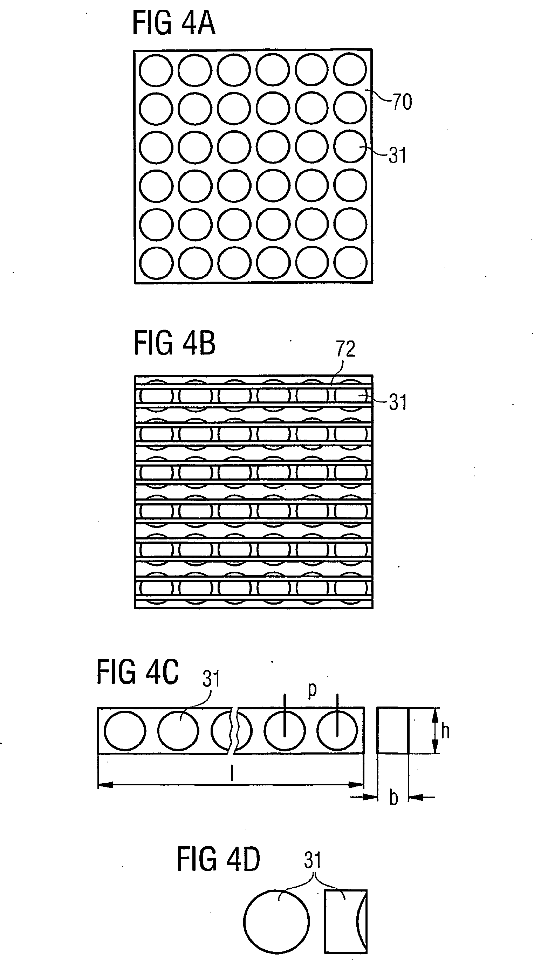

In Verbindung mit den Figuren 4A bis 4D ist ein mögliches Herstellungsverfahren zur Herstellung der Resonatorspiegel 31 beschreiben, wie sie für ein Ausführungsbeispiel der hier beschreiben Halbleitervorrichtung zum Einsatz kommen. Bei diesem Herstellungsverfahren werden beispielsweise Siliziumkugeln in einen Glaswafer 70 geprägt, sodass eine Vielzahl von Resonatorspiegeln 31 in einem Array erzeugt werden können. Figur 4A zeigt die zugehörige schematische Draufsicht auf ein derart erzeugtes Array.

Figur 4B zeigt die Vereinzelung des Arrays 70 entlang von Linien 72. Dadurch werden die in Figur 4C dargestellten Streifen von Mikrospiegeln 31 erzeugt. Eine solche Stange von Mikrospiegeln weist beispielsweise eine Länge 1 von zirka 100 mm auf. Der Abstand p der einzelnen Mikrospiegel 31 voneinander beträgt zirka 2 mm. Die Höhe h der Stange beträgt vorzugsweise zirka 2 mm, die Breite b beträgt vorzugsweise zwischen 0,7 und 2,5 mm.

Eine solche Stange von Mikrospiegeln kann zum Beispiel auf einen Trägerverbund 80 wie er in den Figuren 3A bis 3D gezeigt ist, aufgebracht werden und gemeinsam mit dem Trägerverbund 80 vereinzelt werden. Es ist jedoch auch möglich, dass die Streifen vor Aufbringen auf Einzelträgerbereiche 34 zu einzelnen Resonatorspiegeln 31 vereinzelt werden. Solche Resonatorspiegel 31 sind in der Figur 4D in Draufsicht und Schnittansicht schematisch dargestellt.

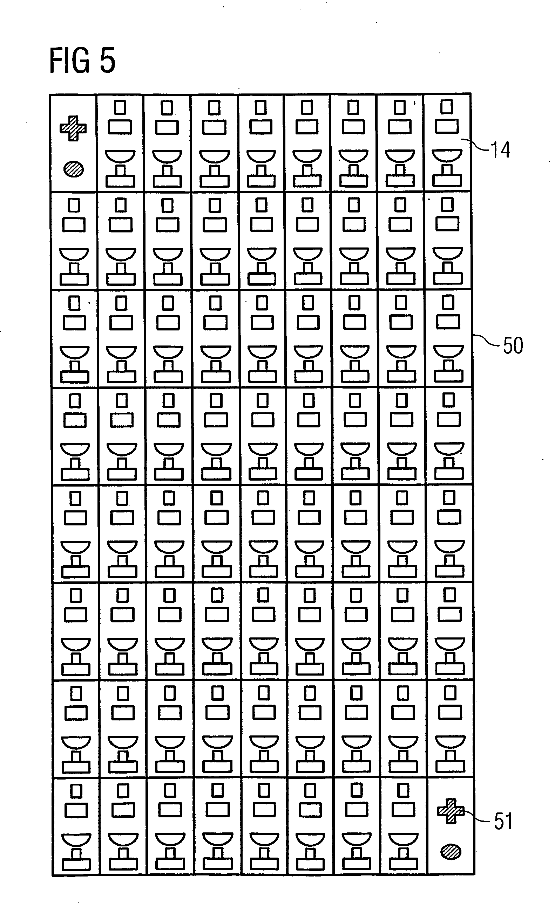

Die Figur 5 zeigt einen Anschlussträgerverbund 50 mit einer Vielzahl von matrixartig angeordneten Anschlussträgern 14 wie sie beispielsweise für die in Verbindung mit den Figuren 1 und 2 beschriebenen Ausführungsbeispiele der hier beschriebenen Halbleitervorrichtung zum Einsatz kommen. Der Anschlussträgerverbund 50 weist Hauptjustagemarken 51 auf, die diagonal an zwei Ecken des Anschlussträgerverbunds 50 angeordnet sind. Bei den Hauptjustagemarken 51 kann es sich beispielsweise um Dünnschichtstrukturierungen im Material des Anschlussträgerverbunds 50 handeln. Weiter ist es möglich, dass es sich bei den Hauptjustagemarken 51 um Justagechips handelt, die beispielsweise aus Silizium, Glas oder einer Keramik bestehen können. Diese Justagechips können Dünnschichtstrukturierungen aufweisen. Die Hauptjustagemarken dienen zur Justage aller Elemente auf dem Anschlussträgerverbund 50. Der Anschlussträgerverbund 50 bildet dabei einen Nutzen. Da die Einzelelemente im Nutzen eine Einheit darstellen, sind folgende Montageprozesse möglich:
- Montage von Elementen als Streifen in einem Schritt und späteres Vereinzeln zusammen mit dem Nutzen,
- Aufbringen von Prismenstreifen oder Linsenstreifen,
- Montage von Einzelteilen, die in einem Saugwerkzeug matrixförmig und selbstjustierend eingelegt sind.

Aufgrund der regelmäßigen matrixartigen Anordnung der Anschlussträger 14 im Anschlussträgerverbund 50 ist eine sequenzielle oder eine gleichzeitige Anordnung einer Vielzahl von Elementen in einem Schritt möglich.

Die Vereinzelung des Anschlussträgerverbunds kann beispielsweise durch Sägen oder Ritzen und Brechen erfolgen. Dabei wird der Anschlussträgerverbund 50 vorzugsweise auf einer Klebefolie in einen Rahmen gespannt.

Der Anschlussträgerverbund 50 hat vorzugsweise eine Größe von 50 mm x 50 mm bis 200 mm x 200 mm. Er kann rund oder rechteckig sein. Vorzugsweise beträgt die Oberflächenrauhigkeit der Anschlussträgeroberseite weniger als 1 µm. Dies ermöglicht eine besonders genaue Justage der einzelnen Elemente auf dem Anschlussträger.

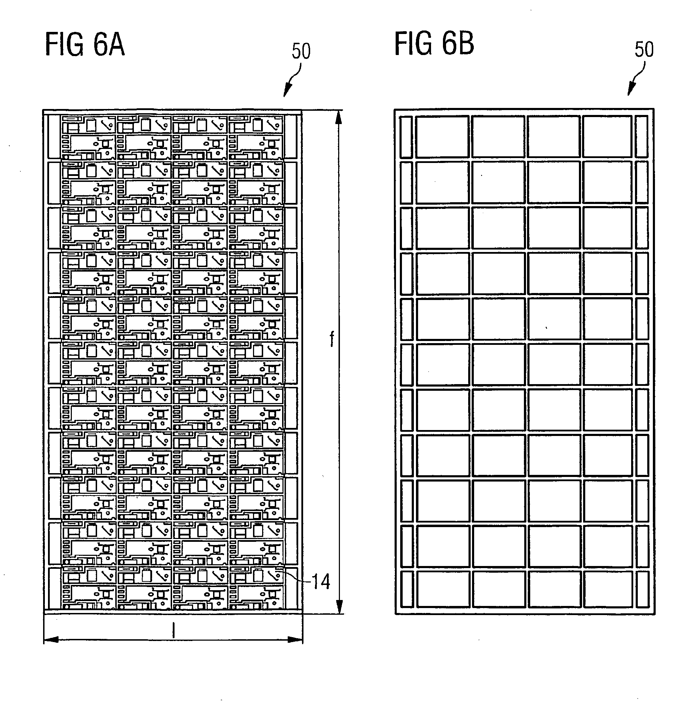

Figur 6A zeigt eine schematische Draufsicht auf einen Anschlussträgerverbund 50 mit einer Vielzahl von matrixartig angeordneten Anschlussträgern 14, wie sie beispielsweise für die in Verbindung mit den Figuren 1 und 2 beschriebenen Ausführungsbeispiele der hier beschriebenen Halbleitervorrichtung zum Einsatz kommen.

Die Länge f des Anschlussträgerverbundes 50 beträgt beispielsweise zwischen 100 und 120 mm, vorzugsweise 110 mm. Die Breite e des Anschlussträgerverbundes 50 beträgt vorzugsweise zwischen 45 und 65 mm, beispielsweise 55 mm. Der Anschlussträgerverbund 50 umfasst in diesem Ausführungsbeispiel 11 mal 4 Anschlussträger 14.

Figur 6B zeigt eine schematische Draufsicht auf die Rückseite des Anschlussträgerverbunds 50.

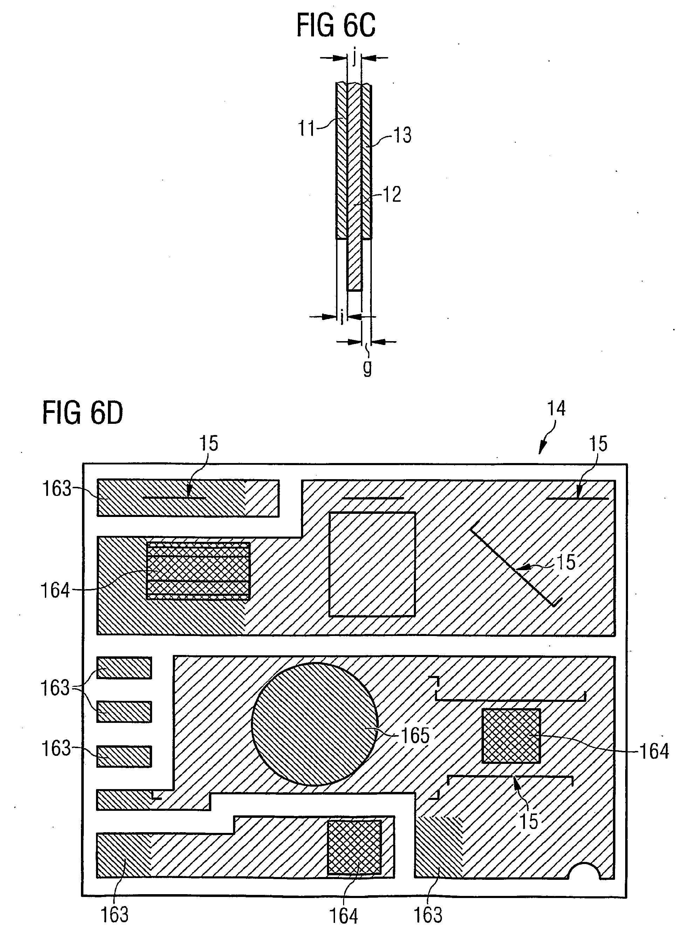

Figur 6C zeigt eine schematische Seitenansicht des Anschlussträgerverbunds 50. Die Breite j des Grundkörpers 12, der beispielsweise ein Aluminiumnitrid enthält oder der aus einem Aluminiumnitrid besteht, beträgt vorzugsweise zwischen 0,25 und 0,45 mm, beispielsweise 0,38 mm. Die Dicke i der Unterseitenmetallisierung 11, die beispielsweise aus Kupfer besteht, beträgt vorzugsweise zwischen 0,2 und 0,4 mm, beispielsweise 0,3 mm. Die Dicke g der strukturierten Oberseitenmetallisierung 13, die beispielsweise aus Kupfer besteht beträgt vorzugsweise zwischen 0,2 und 0,3 mm, beispielsweise 0,25 mm.

Figur 6D zeigt eine schematische Draufsicht auf einen Anschlussträger 14 des Anschlussträgerverbundes 50. Der Anschlussträger 14 weist Drahtbondflächen 163 auf, die zum elektrischen Kontaktieren von Komponenten auf dem Anschlussträger 14 mittels eines Bonddrahts vorgesehen sind. Weiter weist der Anschlussträger 14 Lötflächen 164 auf, auf die aktive Komponenten aufgebracht werden können. Ferner weist der Anschlussträger 14 eine Lötstoppschicht 165 auf.

Die hier beschriebene Halbleitervorrichtung zeichnet sich unter anderem durch ihre besonders kompakte Bauform aus. Dies ermöglicht beispielsweise eine Resonatorlänge von wenigen Millimeter, bevorzugt höchstens 15 mm, besonders bevorzugt höchstens 10 mm. Eine solch geringe Resonatorlänge ermöglicht besonders schnelle Ansprechzeiten bei der Lasererzeugung, wie sie beispielsweise für optische Projektionsanwendungen vorteilhaft sind. Weiter zeichnet sich die hier beschriebenen Halbleitervorrichtung unter anderem dadurch aus, dass insbesondere die im Betrieb Wärme erzeugenden Komponenten wie die Pumpstrahlungsquelle und der oberflächenemittierende Halbleiterkörper in Planarmontage auf einem Träger mit hoher thermischer Leitfähigkeit aufgebracht sind. Dadurch kann die im Betrieb erzeugte Wärme direkt an den Träger abgegeben werden und muss nicht beispielsweise um einen bestimmten Winkel umgelenkt werden. Weiter ermöglicht die thermische Entkopplung von Pumpeinheit und Resonatoraufsatz eine besonders stabile Temperatur des optisch nicht-linearen Kristalls. Auf diese Weise kann beispielsweise besonders gleichmäßige Laserstrahlung im sichtbaren Bereich erzeugt werden.

Diese Patentanmeldung beansprucht die Prioritäten der deutschen Patentanmeldungen 102005063104.5 und 102006017294.9.

## Patentansprüche

1. Optisch pumpbare Halbleitervorrichtung mit
- einem oberflächenemittierenden Halbleiterkörper (1), der eine Strahlungsdurchtrittsfläche (1a) aufweist, die einer Montageebene des Halbleiterkörpers (1) abgewandt ist,
- einem Halbleiterlaserbauelement, das als Pumpstrahlungsquelle (2) vorgesehen ist,
- einem optischen Element (7), das im Betrieb der Halbleitervorrichtung Pumpstrahlung (17) der Pumpstrahlungsquelle (2) auf die Strahlungsdurchtrittsfläche (1a) des oberflächenemittierenden Halbleiterkörpers (1) lenkt, **dadurch gekennzeichnet, dass**
- der oberflächenemittierende Halbleiterkörper (1) in der Montagebene zwischen der Pumpstrahlungsquelle (2) und dem optischen Element (7) angeordnet ist, und
- die Pumpstrahlung (17) über die Strahlungsdurchtrittsfläche (1a) des oberflächenemittierenden Halbleiterkörpers (1) hinweg verläuft, bevor sie auf die Strahlungsdurchtrittsfläche (1a) trifft.

2. Optisch pumpbare Halbleitervorrichtung gemäß dem vorherigen Anspruch,
bei dem die Pumpstrahlungsquelle (2) in einer Ebene parallel zur Montageebene des oberflächenemittierenden Halbleiterkörpers (1) angeordnet ist.

3. Optisch pumpbare Halbleitervorrichtung gemäß zumindest einem der vorherigen Ansprüche,
bei dem der oberflächenemittierende Halbleiterkörper (1), das optische Element (7) und die Pumpstrahlungsquelle (2) auf einem gemeinsamen ersten Träger (14) angeordnet sind, wobei der erste Träger (14) durch einen Anschlussträger gebildet ist, an dem die Pumpstrahlungsquelle (2) elektrisch angeschlossen ist.

4. Optisch pumpbare Halbleitervorrichtung gemäß zumindest einem der vorherigen Ansprüche,
bei dem das optische Element (7) geeignet ist, die Pumpstrahlung (17) in Richtung der Montagebene (1a) des Oberflächenemittierenden Halbleiterkörpers (1) zu lenken.

5. Optisch pumpbare Halbleitervorrichtung gemäß zumindest einem der vorherigen Ansprüche, mit
einem Resonatoraufsatz (40) zur Bildung eines Resonators beinhaltend den oberflächenemittierenden Halbleiterkörper (1), wobei der Resonatoraufsatz (40) der Montageebene des Halbleiterkörpers (1) in einer Hauptabstrahlrichtung des Halbleiterkörpers nachgeordnet ist.

6. Optisch pumpbare Halbleitervorrichtung gemäß dem vorherigen Anspruch,
bei dem der Resonatoraufsatz (40) einen zweiten Träger (34) umfasst, auf dem ein Resonatorspiegel (31) befestigt ist.

7. Optisch pumpbare Halbleitervorrichtung gemäß einem der Ansprüche 5 oder 6,
bei dem der Resonatoraufsatz (40) mittels eines Beabstandungselements (8, 4, 7) von der Montageebene des Oberflächenemittierenden Halbleiterkörpers (1) beabstandet ist.

8. Optisch pumpbare Halbleitervorrichtung gemäß dem vorherigen Anspruch, bei dem das Beabstandungselement (4, 7) ein optisches Element umfasst oder aus einem optischen Element gebildet ist.

9. Optisch pumpbare Halbleitervorrichtung gemäß einem der Ansprüche 5 bis 8,
bei dem der Resonatoraufsatz (40) ein frequenzkonvertierendes Element (32) umfasst.

10. Optisch pumpbare Halbleitervorrichtung gemäß einem der Ansprüche 5 bis 9,
bei dem der Resonatoraufsatz (40) ein Heizelement (60) umfasst, das thermisch leitend mit dem frequenzkonvertierenden Element (31) verbunden ist.

11. Optisch pumpbare Halbleitervorrichtung gemäß Anspruch 3 und 6,
bei dem der zweite Träger (34) eine Metallbeschichtung (60) umfasst, mittels der die Temperatur des Resonatoraufsatz (40) erhöht und ermittelt werden kann, wobei der Resonatoraufsatz (40) elektrisch leitend mit dem ersten Träger (14) verbunden ist.

12. Optisch pumpbare Halbleitervorrichtung gemäß dem vorherigen Anspruch, bei dem die Metallbeschichtung (60) durch eine mäanderartige Platinbeschichtung gebildet ist, die mittels Kontaktstellen (61) elektrisch kontaktierbar ist.

13. Optisch pumpbare Halbleitervorrichtung gemäß Anspruch 3 und einem der Ansprüche 5 bis 12,
bei dem im Betrieb der Halbleitervorrichtung die mittlere Temperatur des Resonatoraufsatzes (40) wenigstens 10K über der mittleren Temperatur des ersten Trägers (14) liegt.

## Claims

1. Optically pumpable semi-conductor device having
- a surface-emitting semi-conductor body (1) which comprises a radiation transmission surface (1a) which is remote from an assembly plane of the semi-conductor body (1)
- a semi-conductor laser component which is provided as a pump radiation source (2),
- an optical element (7) which, when the semi-conductor device is in operation, deflects pump radiation (17) of the pump radiation source (2) onto the radiation transmission surface (1a) of the surface-emitting semi-conductor body (1), **characterised in that**
- the surface-emitting semi-conductor body (1) is disposed in the assembly plane between the pump radiation source (2) and the optical element (7), and
- the pump radiation (17) runs over the radiation transmission surface (1a) of the surface-emitting semi-conductor body (1), before it impinges on the radiation transmission surface (1a).

2. Optically pumpable semi-conductor device as claimed in the preceding claim,
wherein the pump radiation source (2) is disposed in a plane in parallel with the assembly plane of the surface-emitting semi-conductor body (1).

3. Optically pumpable semi-conductor device as claimed in at least one of the preceding claims,
wherein the surface-emitting semi-conductor body (1), the optical element (7) and the pump radiation source (2) are disposed on a common first carrier (14), wherein the first carrier (14) is formed by a connection carrier, to which the pump radiation source (2) is electrically connected.

4. Optically pumpable semi-conductor device as claimed in at least one of the preceding claims,
wherein the optical element (7) is suitable to deflect the pump radiation (17) in the direction of the assembly plane (1a) of the surface-emitting semi-conductor body (1).

5. Optically pumpable semi-conductor device as claimed in at least one of the preceding claims, having a resonator attachment (40) for forming a resonator comprising the surface-emitting semi-conductor body (1)
wherein the resonator attachment (40) is disposed downstream of the assembly plane of the semi-conductor body (1) in a main radiating direction of the semi-conductor body.

6. Optically pumpable semi-conductor device as claimed in the preceding claim,
wherein the resonator attachment (40) comprises a second carrier (34), on which is attached a resonator mirror (31).

7. Optically pumpable semi-conductor device as claimed in any one of claims 5 or 6,
wherein the resonator attachment (40) is maintained at a spaced disposition from the assembly plane of the surface-emitting semi-conductor body (1) by means of a spacing element (8, 4, 7).

8. Optically pumpable semi-conductor device as claimed in the preceding claim, wherein the spacing element (4, 7) comprises an optical element or is formed from an optical element.

9. Optically pumpable semi-conductor device as claimed in any one of claims 5 to 8,
wherein the resonator attachment (40) comprises a frequency-converting element (32).

10. Optically pumpable semi-conductor device as claimed in any one of claims 5 to 9,
wherein the resonator attachment (40) comprises a heating element (60) which is connected in a thermally conductive manner to the frequency-converting element (31).

11. Optically pumpable semi-conductor device as claimed in claim 3 and 6,
wherein the second carrier (34) comprises a metal coating (60) by means of which the temperature of the resonator attachment (40) can be increased and determined, wherein the resonator attachment (40) is connected in an electrically conductive manner to the first carrier (14).

12. Optically pumpable semi-conductor device as claimed in the preceding claim,
wherein the metal coating (60) is formed by means of a serpentine-like platinum coating which is electrically contactable by means of contact sites (61).

13. Optically pumpable semi-conductor device as claimed in claim 3 and any one of claims 5 to 12,
wherein when the semi-conductor device is in operation the average temperature of the resonator attachment (40) is at least 10K above the average temperature of the first carrier (14).

## Revendications

1. Dispositif semi-conducteur pouvant être pompé optiquement, comprenant
- un corps semi-conducteur (1) émettant par la surface, qui présente une surface de passage de rayonnement (la), laquelle est opposée à un plan de montage du corps semi-conducteur (1),
- un composant laser semi-conducteur, qui est ménagé en tant que source de rayonnement de pompage (2),
- un élément optique (7) qui, pendant le fonctionnement du dispositif semi-conducteur, guide le rayonnement de pompage (17) de la source de rayonnement de pompage (2) sur la surface de passage de rayonnement (1a) du corps semi-conducteur (1) émettant par la surface, **caractérisé en ce que**
- le corps semi-conducteur émettant par la surface (1) est disposé dans le plan de montage situé entre la source de rayonnement de pompage (2) et l'élément optique (7), et
- **en ce que** le rayonnement de pompage (17) s'étend au-dessus de la surface de passage de rayonnement (1a) du corps semi-conducteur (1) émettant par la surface avant de toucher la surface de passage de rayonnement (1a).

2. Dispositif semi-conducteur pouvant être pompé optiquement selon la revendication précédente,
dans lequel la source de rayonnement de pompage (2) est disposée dans un plan parallèle au plan de montage du corps semi-conducteur (1) émettant par la surface.

3. Dispositif semi-conducteur pouvant être pompé optiquement selon au moins l'une quelconque des revendications précédentes,
dans lequel le corps semi-conducteur (1) émettant par la surface, l'élément optique (7) et la source de rayonnement de pompage (2) sont disposés sur un premier porteur commun (14), le premier porteur (14) étant formé par un porteur de connexion, auquel la source de rayonnement de pompage (2) est raccordée électriquement.

4. Dispositif semi-conducteur pouvant être pompé optiquement selon au moins l'une quelconque des revendications précédentes,
dans lequel l'élément optique (7) est apte à guider le rayonnement de pompage (17) en direction du plan de montage (1a) du corps semi-conducteur émettant par la surface.

5. Dispositif semi-conducteur pouvant être pompé optiquement selon au moins l'une quelconque des revendications précédentes, comprenant
un embout (40) de résonateur, destiné à former un résonateur, comprenant le corps semi-conducteur (1) émettant par la surface, l'embout (40) de résonateur étant disposé en aval du plan de montage du corps semi-conducteur (1) dans une direction de rayonnement principal du corps semi-conducteur.

6. Dispositif semi-conducteur pouvant être pompé optiquement selon la revendication précédente,
dans lequel l'embout (40) de résonateur comprend un second porteur (34) sur lequel est fixé un miroir de résonateur (31).

7. Dispositif semi-conducteur pouvant être pompé optiquement selon l'une quelconque des revendications 5 ou 6,
dans lequel l'embout (40) de résonateur est distancé du plan de montage du corps semi-conducteur émettant par la surface au moyen d'un élément d'écartement (8, 4, 7).

8. Dispositif semi-conducteur pouvant être pompé optiquement selon la revendication précédente,
dans lequel l'élément d'écartement (4, 7) comprend un élément optique ou est constitué d'un élément optique.

9. Dispositif semi-conducteur pouvant être pompé optiquement selon l'une quelconque des revendications 5 à 8,
dans lequel l'embout (40) de résonateur comprend un élément (32) convertissant la fréquence.

10. Dispositif semi-conducteur pouvant être pompé optiquement selon l'une quelconque des revendications 5 à 9,
dans lequel l'embout (40) de résonateur comprend un élément de chauffage (60) qui est raccordé de manière thermoconductrice à l'élément (31) convertissant la fréquence.

11. Dispositif semi-conducteur pouvant être pompé optiquement selon les revendications 3 et 6,
dans lequel le second porteur (34) comprend un revêtement métallique (60) au moyen duquel la température de l'embout (40) de résonateur peut être augmentée et déterminée, l'embout (40) de résonateur étant raccordé de manière électroconductrice au premier porteur (14).

12. Dispositif semi-conducteur pouvant être pompé optiquement selon la revendication précédente,
dans lequel le revêtement métallique (60) est formé par un revêtement de platine en forme de méandres, lequel peut être contacté électriquement au moyen de points de contact (61).

13. Dispositif semi-conducteur pouvant être pompé optiquement selon la revendication 3 et selon l'une quelconque des revendications 5 à 12,
dans lequel, pendant le fonctionnement du dispositif semi-conducteur, la température moyenne de l'embout (40) de résonateur est située au moins 10 K au-dessus de la température moyenne du premier porteur (14).
